Europäisches Patentamt

(19) European Patent Office

Office européen des brevets

(11) Publication number : **0 345 065 B1**

(12) **EUROPEAN PATENT SPECIFICATION**

(45) Date of publication of patent specification :
31.08.94 Bulletin 94/35

(51) Int. Cl.⁵ : **G11C 5/14,** G11C 11/418,
G11C 11/419

(21) Application number : 89305540.0

(22) Date of filing : 01.06.89

(54) Memories.

(30) Priority : 01.06.88 JP 135101/88
29.07.88 JP 191547/88

(43) Date of publication of application :
06.12.89 Bulletin 89/49

(45) Publication of the grant of the patent :
31.08.94 Bulletin 94/35

(84) Designated Contracting States :
DE FR GB NL

(56) References cited :
EP-A- 0 040 917
EP-A- 0 146 356
EP-A- 0 166 540
US-A- 4 730 279
PATENT ABSTRACTS OF JAPAN, vol. 4, no.
153 (P-33)(635), 25th Oct. 1980 & JP-A-55 101
185

(73) Proprietor : SONY CORPORATION
7-35 Kitashinagawa 6-chome
Shinagawa-ku
Tokyo 141 (JP)

(72) Inventor : Miyaji, Fumio c/o Patents Division
Sony Corporation
6-7-35 Kitashinagawa
Shinagawa-ku Tokyo 141 (JP)
Inventor : Aoki, Yukio c/o Patents Division
Sony Corporation
6-7-35 Kitashinagawa
Shinagawa-ku Tokyo 141 (JP)

(74) Representative : Cotter, Ivan John et al
D. YOUNG & CO.
21 New Fetter Lane
London EC4A 1DA (GB)

Note : Within nine months from the publication of the mention of the grant of the European patent, any
person may give notice to the European Patent Office of opposition to the European patent granted.
Notice of opposition shall be filed in a written reasoned statement. It shall not be deemed to have been
filed until the opposition fee has been paid (Art. 99(1) European patent convention).

## Description

This invention relates to memories, more particularly to static random access memories (RAMS).

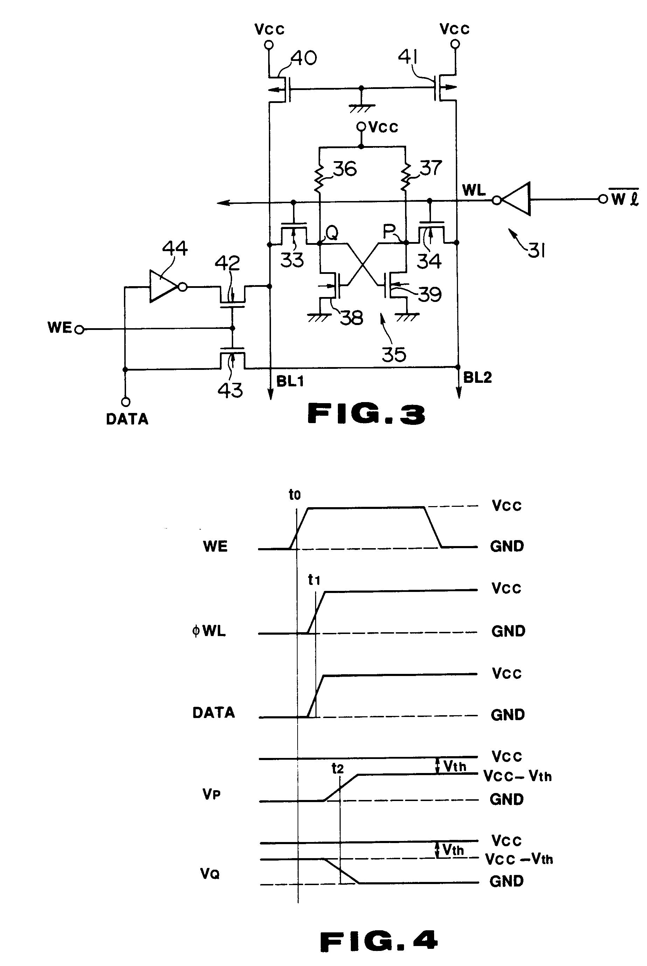

A known static RAM is shown in Figure 3 of the accompanying drawings. The static RAM includes a word line drive circuit 31 having an inverter circuit, a pair of bit lines BL1, BL2 having terminal load transistors 40, 41, a memory cell 35 having word transistors 33, 34 connected to the bit lines BL1, BL2 and data write transistors 42, 43.

The memory cell 35 is constituted mainly by resistor elements 36, 37 and drive transistors 38, 39, as well as the above-mentioned word transistors 33, 34. A power supply voltage Vcc = 5V is applied to one end of each of the resistor elements 36, 37. The gates of the word transistors 33, 34 are connected to a word line WL selected by the word line drive circuit 31. The source and drains of the word transistors 33, 34 are connected to the gates of the drive transistors 38, 39 at nodal points P and Q.

The voltage Vcc = 5V is applied to the load transistors 40, 41, which are provided at terminal points of the bit lines BL1, BL2.

The above-described static RAM operates in the following manner. As shown in Figure 4 of the accompanying drawings, a write enable signal WE rises from ground (GND) to Vcc at a time t0 and, at a slightly later time tl, a signal $\phi$ on the word line WL rises from GND to Vcc. Simultaneously with the rising of the signal $\phi$ on the word line WL, namely at the time t1, a data signal DATA rises from ground GND to Vcc. At this time, the word transistor 34 is turned on and the potential Vp at the point P is changed from GND to a voltage Vp = Vcc - Vth, which is lowered from Vcc by a threshold voltage Vth proper to the word transistor 34. Conversely, the word transistor 33 is turned off, with the potential VQ at the point Q being changed from VQ = Vcc -Vth to GND. The threshold voltage Vth of the word transistors 33, 34 is the threshold voltage for zero substrate bias voltage (VthO) plus an increment of Vth due to body effect ($\Delta$ Vth).

In the above-described known circuit, with a potential on the word line WL of 5V (=Vcc) and the threshold voltage for zero substrate bias voltage VthO being approximately 0.8V, the increment of Vth due to body effect ($\Delta$ Vth) is equal to about 1.0V. Hence, the threshold voltage Vth for the word transistor 33 becomes as high as about 1.8V. Therefore, from the relationship Vp = Vcc - Vth, the voltage Vp at the point P is about 3.2V.

The operating margin for the memory cell is expressed as Vp - VthO. Substituting the above values, Vp - VthO = 3.2V - 0.8V = 2.4V, which level presents no inconveniences as far as the operating margin of the memory cell is concerned.

However, with the tendency towards size reduction of the memory cell that exists, it has become extremely difficult to employ a source voltage Vcc of 5V if the reliability of the memory cell is to be maintained, because it is becoming more and more difficult to produce a sufficient withstanding voltage due, for example, to thickness reduction of the gate oxide film. As a result, one is obliged to use an internal low voltage as far as the memory cell is concerned. An internal low voltage VINT of 3 to 4V has been proposed. However, since the threshold voltage for zero substrate bias voltage (VthO) remains substantially constant, the voltage Vp at the point P in the memory cell is given by Vp = VINT - Vth, whereby Vp = about 1.5 to 2.5V. Thus, the operating margin Vp - VthO is about 0.7 to 1.7V, which is significantly lowered as compared to the case in which the source voltage of 5V is applied.

In view of the above, an embodiment of the invention described below seeks to provide a static RAM employing a word line drive circuit wherein the operating margin during writing may be improved without increasing the memory cell size.

The internal low voltage feature will now be explained in more detail.

The external source voltage is usually set at 5V and a variety of devices are designed to operate at a source voltage of 5V. Therefore, for operating the static RAM at a low voltage, it is necessary to provide an internal low voltage transformation circuit for producing a voltage that is lowered with respect to the source voltage.

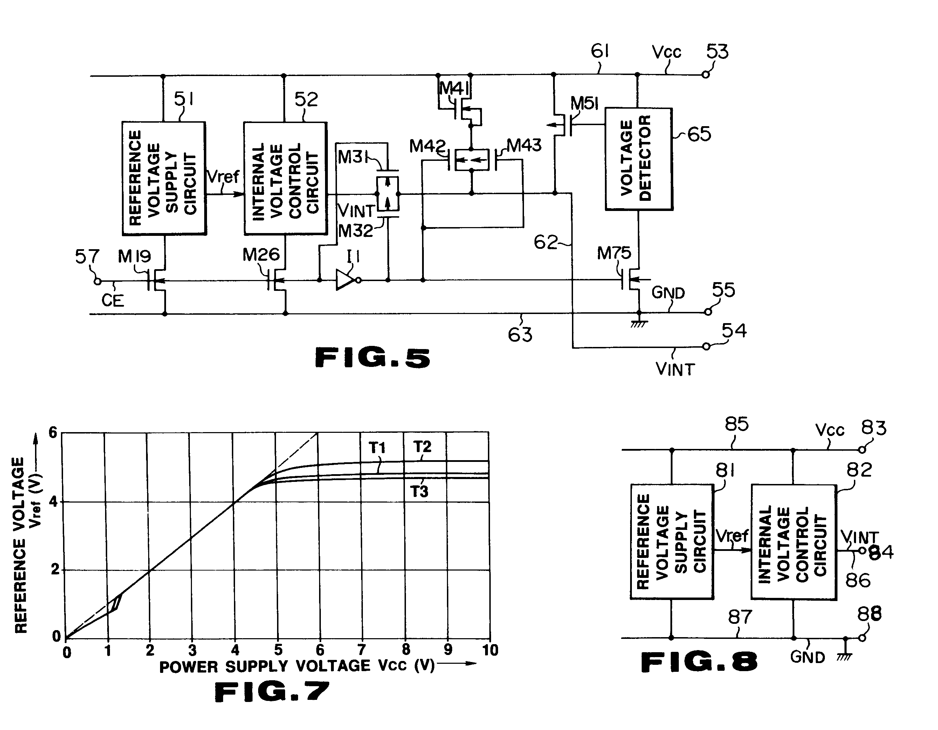

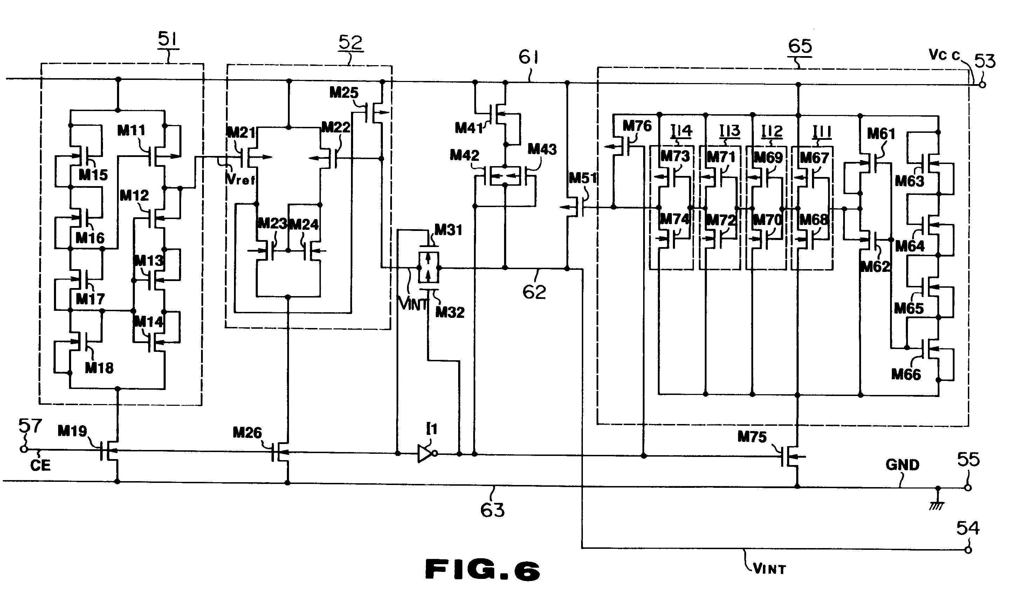

The internal low-voltage transformation circuit is shown in detail in Figure 8 of the accompanying drawings. The circuit of Figure 8 comprises a reference voltage supply circuit 81 and an internal voltage control circuit 82. The circuits 81, 82 are connected between a power source line 85 and a ground line 87. Power source terminals 83, 88 are connected to the power source line 85 and the ground line 87, respectively. The power source voltage Vcc of 5V is supplied to the power source terminal 83 and to the reference voltage supply circuit 81. The reference voltage supply circuit 81 forms a reference voltage Vref from the power source voltage Vcc supplied to the power source terminal 83. The reference voltage Vref is supplied to the internal voltage control circuit 82. Within the internal voltage control circuit 82, the power source voltage Vcc is controlled on the basis of the reference voltage Vref to form an internal low voltage VINT of, for example, 3 to 4V. The internal low voltage VINT is outputted via an internal power source line 86 and an output terminal 84. The static RAM is driven by the internal low voltage VINT.

When the reference voltage supply circuit 81 and the internal voltage control circuit 82 are provided as described above and the internal voltage control circuit 82 is controlled by the reference voltage Vref from the reference voltage supply circuit 82 for forming the internal low voltage VINT, the reference voltage supply circuit 81 and the internal voltage control circuit 82 are always in an active state. This presents the problem that the power consumption is increased. Although it may be contemplated to change the load of the circuit 82 occasionally for achieving a saving in power consumption, the circuits 81 and 82 are basically in an active state at all times, even in this case, so that limitations are placed on reduction of power consumption.

Therefore, the invention described below seeks to provide an internal low voltage transformation circuit wherein power consumption may be reduced.

Patent Abstracts of Japan, vol. 4, no. 153 (P-33) (635), 25 October 1980; (JP-A-55 101 185) describes a static memory circuit using a high voltage for writing and a low voltage for reading.

According to the invention there is provided a static random access memory having a plurality of memory cells each composed of a flip-flop circuit and a pair of word transistors the memory comprising:

a pair of bit lines connected to the word transistors;

a word line connected to gate electrodes of the word transistors; and

an internal low voltage supply means for supplying an internal low voltage pulled down from a power source voltage by a reference voltage supply circuit and an internal voltage control circuit; characterized in that

the internal low voltage supply means is operative to provide the internal low voltage to power the memory cells in an active mode and in a standby mode and to set the reference voltage supply circuit and the internal voltage control circuit to an off state during the standby mode of the memory cell, the internal low voltage supply means being operative to supply a data hold voltage by making use of a voltage pull-down means having a power consumption lower than that of a circuit comprising the reference voltage supply circuit and internal voltage control circuit.

Thus, there is provided a static RAM having a word line drive circuit for driving a word line for selecting memory cells, wherein the word line drive circuit is designed to apply a high voltage to the word line at a write time and a low voltage to the word line at a read-out time to enable the operating margin to be increased without increasing the memory cell size.

Furthermore, there is provided an internal low-voltage transformation circuit in which a voltage pulled down from a source voltage is formed by a reference voltage supply circuit and an internal voltage control circuit to provide a low voltage which is supplied to a static memory, wherein the reference voltage supply circuit and the internal voltage control circuit are set to an off state during a standby or powered-down mode of the static memory and wherein the data hold voltage is obtained by voltage pull-down means, the power consumption of which is lower than that of a circuit consisting of the reference voltage supply circuit and the internal voltage control circuit, whereby the power consumption may be reduced when the static memory is operated at a lower voltage.

The invention will now be further described, by way of illustrative and non-limiting example, with reference to the accompanying drawings, in which:

Figure 1 is a circuit diagram of a static RAM;

Figure 2 is a waveform diagram illustrating the operation of the static RAM shown in Figure 1;

Figure 3 is a circuit diagram of a known static RAM;

Figure 4 is a waveform diagram illustrating the operation of the static RAM shown in Figure 3;

Figure 5 is a block diagram of an embodiment of the invention;

Figure 6 is a circuit diagram showing a preferred form of implementing the embodiment shown in Figure 5;

Figure 7 is a chart illustrating characteristics of an embodiment of the present invention; and

Figure 8 is a block diagram of a known internal voltage supply circuit.

In order to enable the operating margin during writing to be improved without increasing the memory cell size, an embodiment of the invention that will now be described provides a static RAM having a word line drive circuit that applies a high voltage to the word line during a write time or period and applies a low voltage to the word line during a read-out time or period.

The aforementioned low voltage is lower than the aforementioned high voltage and, when applied to the gate of the word transistor, the low voltage provides for sufficient read-out with the transconductance gm of the word transistor and, moreover, does not change the ratio $\beta R$ (see below) of the read-out operation. The high voltage is, for example, higher than the low voltage by a threshold voltage Vth of a word transistor.

The static RAM may be provided for example with an internal (ie on a chip on which the RAM is formed) voltage pull-down means, in which case the aforementioned high voltage may be set for example so as to be equal to an external source voltage Vcc, while the aforementioned low voltage may be set so as to be equal to an internal low voltage VINT provided from the internal low-voltage transformation circuit.

It is assumed that, in a static RAM in which the high level ("H" level) of the bit line is set so as to be equal to the internal low voltage VINT, the high voltage is established during the write time using the word line drive circuit to supply the power source voltage Vcc to a gate of the word transistor. With a potential Vp on the source of the word transistor, Vp = VINT for Vcc - VINT $\geq$ Vth and Vp = Vcc - Vth for Vcc - VINT < Vth.

Hence, the source side potential Vp of the word transistor can be pulled up as compared with the known arrangement so that a satisfactory operating margin may be procured.

In general, data or storage hold properties of a memory cell are determined by the ratio R which is expressed by

$$\beta R = gm(\text{drive transistor})/gm(\text{word transistor})$$

so that, by applying the low voltage, that is an internal low voltage VINT from the word line drive circuit, during the read-out time, the ratio $\beta R$ of the overall memory cell may be maintained constant to allow for size reduction of the circuit element. That is, an element which is smaller in size may be directly employed as compared with the case in which read-out is performed with the transconductance gm of the word line remaining increased and the channel width increased to provide for follow-up of the transconductance gm of the drive transistor.

Illustrative embodiments of the invention will now be explained in detail with reference to the drawings.

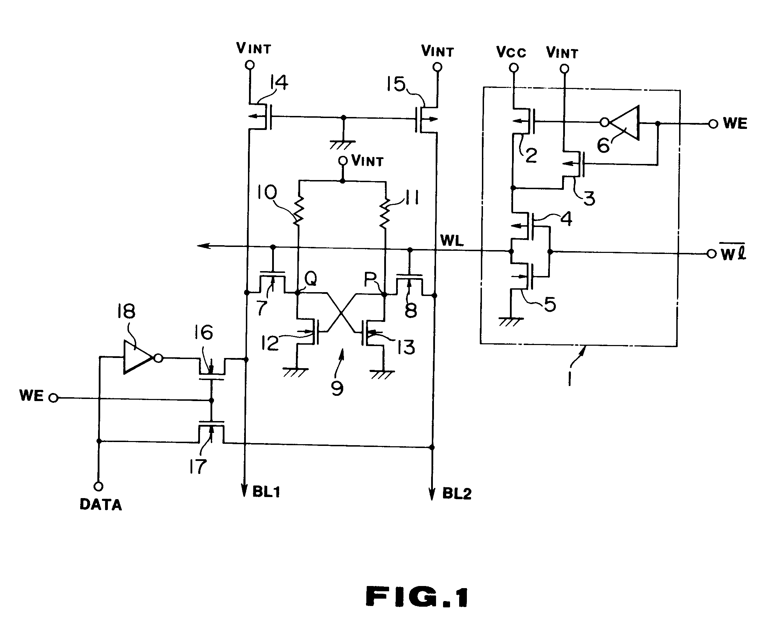

Figure 1 shows a circuit diagram of a static RAM. The static RAM is mainly constituted by a word line drive circuit 1, a pair of bit lines BL1, Bl2 provided with terminal load transistors 14, 15, and a memory cell 9 (only one being shown) having word transistors 7, 8 connected to the bit lines BL1, BL2.

The memory cell 9 has resistor elements 10, 11 and drive transistors 12, 13, in addition to the word transistors 7, 8. One end of each of the resistor elements 10, 11 is supplied with an internal low voltage VINT of, for example, 3 to 4V, while the other ends of the resistor elements are connected to drain electrodes of the drive transistors 12, 13. The source electrodes of the drive transistors 12, 13 are grounded in common, while the gate electrodes thereof are connected at points P and Q with source and gate electrodes of the word transistors 7, 8. The gate electrodes of the word transistors 7, 8 are connected to the word line WL selected from the word line drive circuit 1.

The load transistors 14, 15, which are provided at terminal points of the bit lines BL1 and BL2, have their gates grounded in common and have their sources supplied with the internal low voltage VINT. Data write transistors 16, 17 connected to the bit lines BL1 and BL2 are controlled by a write enable signal WE. Data signals DATA are supplied via the data write transistor 17 to the bit line BL2, and via an inverter circuit 18 to the data write transistor 16.

The word line drive circuit 1 comprises three pMOS transistors 2, 3, 4, and nMOS transistor 5 and an inverter circuit 6. The pMOS transistor 2 has its source supplied with a high voltage (i.e. the source voltage Vcc of, for example, 5V) and has its gate supplied with the write enable signal WE via the inverter circuit 6. The pMOS transistor 3 has its source supplied with the low voltage (i.e. the internal low voltage VINT) and has its gate supplied directly with the write enable signal WE. Each of the pMOS transistors 2, 3 has its drain connected to the source of the pMOS transistor 4. The pMOS transistor 4 and the nMOS transistor 5 make up an inverter circuit and a signal $\overline{wl}$ is supplied to gates of the transistors 4 and 5. The drains of the pMOS transistor 4 and nMOS transistors 5 are connected in common to the word line WL.

The static RAM of Figure 1 operates as follows.

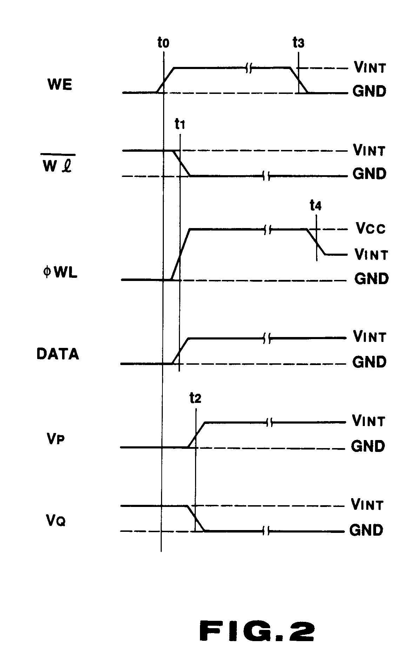

It is assumed that, initially, the potential of the write enable signal WE is at ground (GND) level, that of the signal $\overline{wl}$ is at the VINT level, and those of the signal $\phi wl$ of the word line WL and of the data signal DATA are at GND level, as shown in Figure 2. It is also assumed that the data of a preceding cycle still remains and the potential Vp at a point P in the memory cell is at GND level, while the potential VQ at a point Q is at VINT level.

When writing is thereafter effected, the potential of the write enable signal WE rises from GND to VINT and, after a certain time delay, the potential of the signal wl rises from VINT to GND at a time t1. In the word line drive circuit 1, the pMOS transistor 2 is turned on, the pMOS transistor 3 is turned off and the pMOS transistor 4 is turned on, whereby the potential of the signal $\phi$ WL on the word line WL rises from GND to the Vcc level.

Assuming that data is inputted at this time and the data signal DATA rises at the time t1 to the VINT level, the bit line BL1 is at GND level while the bit line BL2 is at VINT level.

Then, at a time t2, the gate and the drain of the word transistor 8 are at the Vcc level and at the VINT level, respectively. Assuming that the threshold voltage Vth of the word transistor 8 is given by $Vth = VthO + \Delta Vth$, the potential Vp at the point P is given by Vp = VINT for $Vcc - VINT \geqq Vth$, and by $Vp = Vcc - Vth$ for $Vcc - VINT < Vth$.

Thus, by pulling up the gate potential of the word transistor to Vcc during writing, the potential at the point P can be raised to procure an operating margin for the static RAM. On the side of the word transistor 7, the potential at the point Q falls from VINT to GND.

During the read-out time, the write enable signal WE falls from VINT to GND at a time t3. At this time, the pMOS transistors 2 and 3 in the word line drive circuit 1 are turned off and turned on, respectively, with the voltage $\phi$ WL on the word line WL falling at a time t4 to the VINT level, which is the low voltage during read-out. In this manner, by supplying VINT from the word line drive circuit 1, a balanced state of gm for the overall memory cell, that is a constant ratio $\beta R$, which is determined by the ratio of the gm of the driven transistor and the gm of the word transistor, is maintained, such that a reduction in size of the circuit elements may be achieved without unnecessarily increasing the channel width, for example, of the circuit elements.

As for the unselected word line WL, the nMOS transistor 5 is turned on and set to the GND level.

In order that power consumption may be reduced, the circuit in Figure 5 provides an internal low-voltage transformation circuit in which a source voltage Vcc is pulled down by a reference voltage supply circuit 51 and an internal voltage control circuit 52 to form an internal low voltage VINT which is supplied to a static memory, wherein, during a standby or powered-down mode, the reference voltage supply circuit 51 and the internal voltage control circuit 52 are set to an off state and a data hold voltage is produced using a power pull down transistor M41 having a power consumption lower than that of the circuit consisting of the reference voltage supply circuit 51 and the internal voltage control circuit 52.

The internal low voltage VINT of, for example, 3 to 4 V, pulled down from the power source voltage of, for example, 5V, may be obtained from the reference voltage supply circuit 51 and the internal voltage control circuit 52. When the static RAM is in an active or operating state, the internal low voltage VINT produced as described above is supplied to the static RAM. When the static RAM is in the stand-by state, the operation of the reference voltage supply circuit 51 and the internal voltage control circuit 52 is terminated and the data hold voltage is maintained by the MOS transistor M41. In this manner, the operation of the reference voltage supply circuit 51 and the internal voltage control circuit 52 is terminated during the standby mode for realising a saving in power consumption.

As shown in Figure 5, the reference voltage supply circuit 51 and the internal voltage control circuit 52 are connected between a power source line 61 and a ground line 63. The operation of the reference voltage supply circuit 51 and that of the internal voltage control circuit 52 are controlled by MOS transistors M19, M26, respectively. A power source terminal 53 and a ground terminal 55 are connected to the power source line 61 and the ground line 63, respectively.

The internal low voltage VINT, pulled down from the power source voltage Vcc, is produced from the reference voltage supply circuit 51 and the internal voltage control circuit 52. The internal low voltage VINT formed in the internal voltage control circuit 52 is outputted at an output terminal 54 via a transmission gate formed by MOS transistors M31 and M32 and an internal power source line 62.

The reference voltage supply circuit 51 and the internal voltage control circuit 52 are in operation only when the static RAM is in the active or operating mode, and are out of operation when the static RAM is in the standby mode. This allows the power consumption to be reduced. A chip enable signal CE, for example, may be employed for detecting whether the static RAM is in the active mode or in the standby mode.

A terminal 57 acts as an input terminal for the chip enable signal CE. The static RAM is in the active mode or in the standby mode when, for example, the chip enable signal is "H" or "L" respectively. The chip enable signal CE is supplied to a transmission gate including the MOS transistors M19, M26, M32.

When the chip enable signal CE is "H", for example, with the static RAM then being in the active state, the transmission gate inclusive of the MOS transistors M19, M26, M31, M32 is turned on. Thus, the reference voltage supply circuit 51 and the internal voltage control circuit 52 are in operation. With the circuits 51 and 52 in operation, the reference voltage Vref is formed in the circuit 51 from the source voltage Vcc and supplied to the circuit 52 where the source voltage Vcc is controlled on the basis of the reference voltage Vref. In this manner, the internal low voltage VINT based on the reference voltage Vref is formed. The internal low voltage VINT thus formed is outputted from the output terminal 54 via the transmission gate inclusive of the MOS transistors M31 and M32 and the internal power source line 62.

When the chip enable signal CE is "L", with the static RAM then being in the standby state, the transmission gate inclusive of the MOS transistors M19, M26; M31, M32 is turned off. Thus, the operation of the reference voltage supply circuit 51 and that of the internal voltage control circuit 52 are discontinued. At this time, since the internal low voltage VINT is not outputted from the internal voltage control circuit 52, it is necessary to supply a data hold voltage to the memory cell. A voltage pull-down circuit including the MOS transistor M41 is provided for maintaining the data hold voltage. In this manner, the data hold voltage may be positively provided even when the operation of the circuits 51 and 52 is discontinued.

In order that a data hold voltage of predetermined level may be procured when the power source voltage is lowered, a voltage detection circuit (voltage detector) 65 is provided between the power source line 61 and the ground line 63 for sensing the level of the power source voltage Vcc. An MOS transistor M51 is controlled as a function of the sensed voltage level to compensate for lowering of the power source voltage Vcc. The voltage detection circuit 65 is controlled by an MOS transistor M75 so as to be in operation only during the standby mode when the chip enable signal CE is "L".

Figure 6 shows in detail a preferred circuit implementation of the embodiment of Figure 5. As shown in Figure 6, the reference voltage supply circuit 51, forming the reference voltage Vref from the power source voltage Vcc, is made up of a P channel MOS transistor M11, N channel MOS transistor M12 to M14 and N channel MOS transistors M15 to M18.

In the reference voltage supply circuit 51 shown in Figure 6, the P channel MOS transistor M11 has its well and source connected together, while each of the N channel MOS transistors M12 and M14 has its well and drain connected together. Between the power source line 61 and the drain of the N channel MOS transistor M19 controlling the operation of the reference voltage supply circuit 51, there is provided a series circuit comprising the P channel MOS transistor M11 having its well and source connected together and the N channel MOS transistors M12 to M14 each having its well and drain connected together, as described above. An output terminal for the reference voltage Vref is connected to a junction between the transistors M11 and M12. The N channel MOS transistor M19 has a source connected to the ground line 63. The N channel MOS transistor 19 has its gate connected to the input terminal 57 for the chip enable signal CE.

Each of the N channel MOS transistors M15 to M18 has its well and source connected together, and its gate and drain connected together. Between the power source line 61 and the drain of the N channel MOS transistor M19, there is connected a series circuit comprising the N channel MOS transistors M15 to M18, each having its well and source connected together, and its gate and drain similarly connected together.

The junction between the N channel MOS transistor M16 and the N channel MOS transistor M17 is connected to the gate of the P channel MOS transistor M11. In like manner, the junction between the N channel MOS transistor M17 and the N channel MOS transistor M18 is connected to the gates of the N channel MOS transistors M12 to M14.

The operation of the reference voltage supply circuit 51 is controlled by the chip enable signal CE from the terminal 57. That is, when the chip enable signal CE becomes "H", the N channel MOS transistor M19 is turned on so that the reference voltage supply circuit 51 comes into operation. When, on the other hand, the chip enable signal CE is "L", the N channel MOS transistor M19 is turned off to terminate the operation of the reference voltage supply circuit 51.

Figure 7 shows characteristic changes of the reference voltage Vref at the junction between the P channel MOS transistor M11 and the N channel MOS transistor M12 with respect to changes of the source voltage Vcc supplied to the power source terminal 53 when the reference voltage supply circuit 51 is in the active state. That is, the P channel MOS transistor M11 and the three N channel MOS transistors M12 to M14 are connected in series with one another. Diodes are formed by the interconnections of the well regions and the source diffusion regions of the three N channel MOS transistors M12 to M14. Therefore, as the source voltage Vcc is increased gradually, the reference voltage Vref is increased gradually until the voltage Vref becomes constant at approximately 3 VF, where VF denotes the diode threshold voltage. In this manner, a constant reference voltage Vref may be produced by the reference voltage supply circuit 51 despite fluctuations in the source voltage. It has been confirmed that the reference voltage supply circuit 51 is not affected severely by temperature fluctuations. In Figure 7, T1, T2 and T3 show the characteristics at 25°C, 125°C and -10°C, respectively. It can be seen from Figure 7 that the characteristics do not change markedly with changes in temperature.

The internal voltage control circuit 52 controls the power source voltage Vcc based on the reference voltage Vref to form the internal low voltage VINT. The internal voltage control circuit 52 is made up of P channel MOS transistors M21, M22, N channel MOS transistors M23, M24 and a P channel MOS transistor M25.

The P channel MOS transistors M21 and M22 have their sources connected in common at a junction point which is connected to the power source line 61. The P channel MOS transistor M21 has its drain connected to the drain of the N channel MOS transistor M23. The P channel MOS transistor M22 has its drain connected to the drain of the N channel MOS transistor M24. The N channel MOS transistor M23 has its gate connected in common to the gate of the N channel MOS transistor M24, while the N channel MOS transistor M24 has its gate connected in common to its drain, such that a current mirror circuit is formed by the N channel MOS transistors M23 and M24. The N channel MOS transistors M23 and M24 have their sources connected to the drain of the N channel MOS transistor M26 controlling the operation of the internal voltage control circuit 52. The N channel MOS transistor M26 has its source connected to the ground line 63. The N channel MOS transistor M26 has its gate connected to the input terminal 57 for the chip enable signal CE.

The P channel MOS transistor M21 has its gate connected to the junction between the P channel MOS transistor M11 and the N channel MOS transistor M12 acting as the output terminal for the reference voltage Vref. The P channel MOS transistor M25 is provided between the gate of the P channel MOS transistor M22 and the power source line 61 and an output terminal for the internal low voltage VINT is connected to the gate of the P channel MOS transistor M22. The P channel MOS transistor M25 has its gate connected to a junction between the drain of the P channel MOS transistor M21 and the drain of the N channel MOS transistor M23.

The operation of the internal voltage control circuit 52 is controlled by the chip enable signal from the terminal 57. That is, when the chip enable signal CE becomes "H", the N-channel MOS transistor M26 is turned on, so that the internal voltage control circuit 52 comes into operation. When the chip enable signal CE becomes "L", the N channel MOS transistor M26 is turned off so that the operation of the internal voltage control circuit 52 ceases.

In the internal voltage control circuit 52 shown in Figure 6, the P channel MOS transistor M21 and the P channel MOS transistor M22 make up a differential circuit. The output from the junction between the P channel MOS transistor 21 and the N channel MOS transistor M23 is fed back via the P channel MOS transistor M25 to the P channel MOS transistor M22. Thus, the P channel MOS transistor M25 is controlled so that the voltage applied to the gate of the P channel MOS transistor M21 will be equal to the voltage applied to the gate of the P channel MOS transistor M22. Since the reference voltage Vref is applied to the gate of the P channel MOS transistor M21, the gate voltage of the P channel MOS transistor M22 is controlled so as to be equal to the reference voltage Vref, so that an internal low voltage VINT equal to the reference voltage Vref is produced at the junction between the source of the P channel MOS transistor M25 and the gate of the N channel MOS transistor M22.

The internal low voltage VINT produced in the internal voltage control circuit 52 is outputted from the internal low voltage output terminal 54 via a transmission gate comprising the N channel MOS transistor M31 and P channel MOS transistor M32 and via the internal power source line 62. The gate of the N channel MOS transistor M31 is supplied with the chip enable signal CE from the terminal 57, while the gate of the P channel MOS transistor M32 is supplied with the chip enable signal CE from the terminal 57 after inversion by an inverter I1. Hence, when the chip enable signal CE is "H", the transmission gate comprising the N channel MOS transistor M31 and the P channel MOS transistor M32 is turned on, so that the internal low voltage VINT formed by the internal voltage control circuit 52 is outputted from the internal low voltage output terminal 54. When the chip enable signal CE is "L", the transmission gate comprising the N channel MOS transistor M31 and the P channel MOS transistor M32 is turned off.

In this manner, the internal low voltage VINT is outputted from the output terminal 54 when the chip enable signal CE is "H", but the internal low voltage VINT formed in the internal voltage control circuit 52 is not outputted from the internal low voltage output terminal 54 when the chip enable signal CE is "L".

For maintaining the date storage voltage of the memory cell, the N channel MOS transistor M41 (having its drain and its gate connected together and its well and its source similarly connected together) is connected between the power source line 61 and the internal power source line 62 via a transmission gate consisting of the N channel MOS transistor M42 and P channel MOS transistor M43. The gates of the N channel MOS transistor M42 and the P channel MOS transistor M43 are supplied with the chip enable signal CE inverted by the inverter I1.

The transmission gate comprising the N channel MOS transistor M42 and P channel MOS transistor M43 is turned on perpetually, notwithstanding the level of the chip enable signal CE. When the chip enable signal CE is "L", so that the internal low voltage VINT formed inside the internal voltage control circuit 52 is no longer outputted at the internal low voltage output terminal 54 via the internal power source line 62, the data hold voltage from the N channel MOS transistor M41 is applied via the internal power source line 62 to the memory cell to ensure the data hold voltage.

The N-channel MOS transistor M41 is small in size and has only a low power consumption. On the other hand, when the internal low voltage V formed in the internal voltage control circuit 52 is outputted at the output terminal 54, the voltage pull-down circuit comprising the N channel MOS transistor M41 can be disregarded.

It is possible that the data hold voltage formed by the voltage pull-down circuit formed by the N channel MOS transistor M41 may be lowered under the adverse effect of fluctuations in the power source voltage Vcc so as to become unable to provide the data hold voltage. Thus, the voltage detection circuit 65 is provided for sensing fluctuations in the power source voltage Vcc. The P channel MOS transistor M51 is controlled by the output of the voltage detection circuit 65 to compensate for lowering of the data hold voltage.

The voltage detection circuit 65 is made up of N channel MOS transistors M61 and M62 for detecting the level of the power source voltage Vcc; N channel MOS transistors M63 to M66 forming a voltage to be supplied to the gates of the N channel MOS transistors M61 and M62; and a P channel MOS transistor M67 and an N channel MOS transistor M68, a P channel MOS transistor M69 and an N channel MOS transistor M70, a P channel MOS transistor M71 and an N channel MOS transistor M72, and a P channel MOS transistor M73 and an N channel MOS transistor M74, such pairs of transistors constituting inverters I11 to I14, respectively.

Each of the N channel MOS transistors M61 and M62 has its well and drain connected together, and a series circuit of the N channel MOS transistors M61 and M62 each having its well and drain connected in common is connected between the power source line 61 and the drain of an N channel MOS transistor M75 controlling the operation of the voltage detection circuit 65.

Each of the N channel MOS transistors M63 to M66 has its well and source connected together, and has its gate and drain connected together. A series circuit of the N channel MOS transistors M63 to M66 having their wells and sources connected together and also having their gates and drains connected together is connected between the power source line 61 and the drain of the N channel MOS transistor M75.

The junction between the N channel MOS transistor and the N channel MOS transistor M66 is connected to the gates of the N channel MOS transistors M61 and M62.

The P channel MOS transistor M67 has its drain connected to the drain of the N channel MOS transistor M68, the P channel MOS transistor M67 has its source connected to the power source line 61, and the N channel MOS transistor M68 has its source connected to the drain of the N channel MOS transistor M75, with the P channel MOS transistor M67 and the N channel MOS transistor M68 forming the inverter I11. The gates of the P channel MOS transistors M67 and M68, acting as an input terminal of the inverter I11, are connected to a junction between the N channel MOS transistor M61 and the MOS transistor M62. The junction between the drain of the P channel MOS transistor M67 and the N channel MOS transistor M68, acting as an output terminal of the inverter I11, is connected to the junction between the gate of the P channel MOS transistor M69 and the gate of the N channel MOS transistor M70, acting as an input terminal of the inverter I12.

The P channel MOS transistor M69 has its drain connected to the drain of the N channel MOS transistor M70, the P channel MOS transistor M69 has its source connected to the power source line 61 and the N channel MOS transistor M70 has its source connected to the drain of the N channel MOS transistor M75, and the P channel MOS transistor M69 and the N channel MOS transistor M70 forming the inverter I12. The junction between the drain of the P channel MOS transistor M69 and the drain of the N channel MOS transistor M70, acting as an output terminal of the inverter I12, is connected to the gate of the P channel MOS transistor M71 and the gate of the N channel MOS transistor M72, acting as an input terminal of the inverter I13.

The P channel MOS transistor M71 has its drain connected to the drain of the N channel MOS transistor M72, the P channel MOS transistor M71 has its source connected to the power source line 61 and the N channel MOS transistor M72 has its source connected to the drain of the N channel MOS transistor M75, with the P channel MOS transistor M71 and the N channel MOS transistor M72 forming the inverter 13. The junction between the drain of the P channel MOS transistor M71 and the drain of the N channel MOS transistor M72 is connected to the gate of the P channel MOS transistor M73 and the gate of the N channel MOS transistor M74, acting as an input terminal of the inverter I14.

The P channel MOS transistor M73 has its drain connected to the drain of the N channel MOS transistor M74, while having its source connected to the power source line 61, and the N channel MOS transistor M74 has its source connected to the drain of the N channel MOS transistor M75, with the P channel MOS transistor M73 and the N channel MOS transistor M74 forming the inverter I14.

The junction between the N channel MOS transistor M73 and the N channel MOS transistor M74, acting as an output terminal of the inverter I14, is connected to the gate of the P channel MOS transistor M51. The P channel MOS transistor M51 is provided between the power source line 61 and the internal power source line 62. A P channel MOS transistor M76 is provided between the power source line 61 and the junction between the N channel MOS transistor M73 and the N channel MOS transistor M74. The P channel MOS transistor M76 has its gate connected to the output terminal of the inverter I1.

When the chip enable signal CE becomes "H" to render the static RAM operative, the output of the inverter I1 becomes "L", so that the N channel MOS transistor M75 is turned off and the P channel MOS transistor M76 is turned on. Thus, the operation of the voltage detection circuit 15 ceases, while the P channel MOS transistor M76 is turned on, so that the P channel MOS transistor M51 is turned off.

When the chip enable signal CE is "L", to produce the standby state of the static RAM, the output of the inverter I1 becomes "H", so that the N channel MOS transistor M75 is turned on and the P channel MOS transistor M76 is turned off, the voltage detection circuit 65 coming into operation.

With the voltage detection circuit 65 in operation, the voltage at the junction between the P channel MOS transistor M61 and the N channel MOS transistor M62 is changed with changes in the source voltage Vcc, such that the level of the source voltage Vcc is detected at the junction between the P channel MOS transistor M61 and the N channel MOS transistor M62. The thus sensed voltage level is supplied to the gate of the P channel MOS transistor M51 via the inverters I11 to I14. This affords compensation of the data hold voltage in the case of lowering of the source voltage Vcc.

That is, when the level of the source voltage Vcc is not less than a predetermined value, the voltage detected at the junction between the P channel MOS transistor M61 and the N channel MOS transistor M62 is not less than a predetermined value, so that the output of the inverter I11 becomes "L", the output of the inverter I12 becomes "H", the output of the inverter I13 becomes "L" and the output of the inverter I14 becomes "H". Thus, the P channel MOS transistor M51 is turned off.

When the source voltage Vcc is not more than the predetermined value, the voltage detected at the junction between the P channel MOS transistor M61 and the N channel MOS transistor M62 is not more than the predetermined value, the output from the inverter I11 being "H", the output from the inverter I12 being "L", the output from the inverter I13 being "H" and the output from the inverter I14 being "L". Thus, the P channel MOS transistor M51 is turned on. With the P channel MOS transistor M51 turned on, the power source line 61 and the internal power source line 62 are connected to each other and the voltage outputted from the internal low voltage output terminal 54 is pulled up.

It will be seen from the foregoing that, since there is provided a static RAM in which the word line drive circuit acts to supply a high voltage to the word line during writing, the potential at the source side or the driver transistor side of the word transistor is increased to improve the operating margin of the memory cell. In addition, during read-out, the low voltage is applied from the word line drive circuit to the word line to allow for effective data storage while the cell is of a minimum size.

Secondly, while the static RAM is in the active state, the internal low voltage VINT, produced as a result of coming into operation of the reference voltage supply circuit 51 and the internal voltage control circuit 52, is supplied to the static RAM. When the static RAM is in the standby mode, the operation of the reference voltage supply circuit 51 and the internal voltage control circuit 52 is discontinued and a data hold voltage is ensured by the MOS transistor M41. In this manner, the operation of the reference voltage supply circuit 51 and the internal voltage control circuit 52 is discontinued to achieve a saving in power consumption.

## Claims

1. A static random access memory having a plurality of memory cells (9) each composed of a flip-flop circuit and a pair of word transistors (7, 8), the memory comprising:

    a pair of bit lines (BL1, BL2) connected to the word transistors (7, 8);

    a word line (WL) connected to gate electrodes of the word transistors (7, 8); and

    an internal low voltage supply means for supplying an internal low voltage (VINT) pulled down from a power source voltage (Vcc) by a reference voltage supply circuit (51) and an internal voltage control circuit (52); characterized in that

    the internal low voltage supply means is operative to provide the internal low voltage (VINT) to power the memory cells (9) in an active mode and in a standby mode and to set the reference voltage supply circuit (51) and the internal voltage control circuit (52) to an off state during the standby mode of the memory cell (9), the internal low voltage supply means being operative to supply a data hold voltage by making use of a voltage pull-down means having a power consumption lower than that of a circuit comprising the reference voltage supply circuit (51) and internal voltage control circuit (52).

2. A memory according to claim 1, wherein said voltage pull-down means is a constant voltage circuit formed by an MOS transistor (M41).

3. A memory according to claim 1 or claim 2, wherein the reference voltage supply circuit (51) and internal voltage control circuit (52) are arranged to be turned off by a chip enable signal (CE).

4. A memory according to claim 1, claim 2 or claim 3, comprising a voltage detection circuit (65) for sensing fluctuations in the power source voltage (Vcc) and means (M51) for compensating lowering of the power source voltage depending on the results of such sensing.

## Patentansprüche

1. Statischer Direktzugriffsspeicher mit mehreren Speicherzellen (9), die jeweils aus einer Flipflop-Schaltung und aus einem Worttransistorpaar (7, 8) bestehen, wobei der Speicher aufweist:

    zwei Bitleitungen (BL1, BL2), die mit den Worttransistoren (7, 8) verbunden sind,

    eine Wortleitung (WL), die mit Gateelektroden der Worttransistoren (7, 8) verbunden ist; und

    interne Niederspannungsliefermittel zum Liefern einer internen Niederspannung (VINT), die von einer Betriebsversorgungsspannung (V$_{CC}$) durch eine Referenzspannungslieferschaltung (51) und eine interne Spannungsregelschaltung (52) abgesenkt wird, dadurch gekennzeichnet,

    daß die internen Niederspannungsliefermittel so arbeiten, daß sie die interne Niederspannung (VINT) dazu vorsehen, die Speicherzellen (9) in einem aktiven Modus und in einem Bereitschaftsmodus mit Energie zu versorgen, und daß sie die Referenzspannungslieferschaltung (51) und die interne Spannungsregelschaltung (52) in einen AUS-Status während des Bereitschaftsmodus der Speicherzelle (9) stellen, wobei die internen Niederspannungsliefermittel so arbeiten, daß sie eine Datenhaltespannung durch Verwendung von Spannungsabsenkungsmitteln liefern, die einen Leistungsverbrauch haben, der niedriger als der einer Schaltung ist, die die Referenzspannungslieferschaltung (51) und die interne Spannungsregelschaltung (52) umfaßt.

2. Speicher nach Anspruch 1, wobei die Spannungsabsenkungsmittel durch eine Konstantspannungsschaltung gebildet sind, die durch einen MOS-Transistor (M41) gebildet ist.

3. Speicher nach Anspruch 1 oder 2. wobei die Referenzspannungslieferschaltung (51) und die interne Spannungsregelschaltung (52) so eingerichtet sind, daß sie durch ein Chipfreigabesignal (CE) abschaltbar sind.

4.  Speicher nach Anspruch 1, 2 oder 3 mit einer Spannungsermittlungsschaltung (65) zum Abtasten von Schwankungen der Betriebsversorgungsspannung (V$_{CC}$) und Mitteln (M51) zur Kompensation einer Verminderung der Betriebsversorgungsspannung abhängig von den Ergebnissen eines solchen Abtastens.

**Revendications**

1.  Mémoire vive statique ayant une pluralité de cellules de mémoire (9), chacune composée d'un circuit à bascule et d'une paire de transistors de mot (7, 8), la mémoire comprenant :
    - une paire de lignes d'élément binaire (BL1, BL2) connectées aux transistors de mot (7, 8);
    - une ligne de mot (WL) connectée aux électrodes de grille des transistors de mot (7, 8); et
    - des moyens d'alimentation à basse tension interne pour fournir une basse tension interne (VINT) abaissée à partir d'une tension de source d'énergie (Vcc) par un circuit d'alimentation à tension de référence (51) et un circuit de commande de tension interne (52), caractérisé en ce que :
    - les moyens d'alimentation à basse tension interne fonctionnent pour fournir la basse tension interne (VINT) pour alimenter en énergie les cellules de mémoire (9) dans un mode actif et dans un mode d'attente et pour mettre le circuit d'alimentation à tension de référence (51) et le circuit de commande de tension interne (52) à l'état ouvert dans le mode d'attente de la cellule de mémoire (9), les moyens d'alimentation à basse tension interne fonctionnant pour fournir une tension de maintien des données en utilisant des moyens d'abaissement de tension ayant une consommation d'énergie plus faible que celle d'un circuit comprenant le circuit d'alimentation à tension de référence (51) et le circuit de commande de tension interne (52).

2.  Mémoire selon la revendication 1, dans laquelle lesdits moyens d'abaissement de tension sont un circuit à tension constante formé par un transistor MOS (M41).

3.  Mémoire selon la revendication 1 ou 2, dans laquelle le circuit d'alimentation à tension de référence (51) et le circuit de commande de tension interne (52) sont agencés pour être ouverts par un signal de validation de boîtier (CE).

4.  Mémoire selon la revendication 1, 2 ou 3, comprenant un circuit de détection de tension (65) pour détecter des fluctuations dans la tension (Vcc) de la source d'énergie et des moyens (M51) pour compenser l'abaissement de la tension de la source d'énergie selon les résultats de cette détection.

**FIG.1**

EP 0 345 065 B1

# FIG.2

EP 0 345 065 B1

FIG.3

FIG.4

**FIG.5**

Vcc 53
65
VOLTAGE DETECTOR
61
M51
GND 55
M75
VINT 54
62
M43
M41
M42
63
M31
VINT M32
I1
52
INTERNAL VOLTAGE CONTROL CIRCUIT
M26
51
REFERENCE VOLTAGE SUPPLY CIRCUIT
Vref
M19
CE
57

**FIG.8**

Vcc 83
82
VINT 84
86
INTERNAL VOLTAGE CONTROL CIRCUIT
85
81
Vref
REFERENCE VOLTAGE SUPPLY CIRCUIT
87
GND 88

**FIG.7**

REFERENCE VOLTAGE Vref (V)
6
4
2
0
T1
T2
T3
POWER SUPPLY VOLTAGE Vcc (V)
0 1 2 3 4 5 6 7 8 9 10

FIG.6